(19) Europäisches Patentamt
European Patent Office
Office européen des brevets

(11) **EP 4 468 078 A2**

(12) **EUROPEAN PATENT APPLICATION**

(43) Date of publication:
**27.11.2024 Bulletin 2024/48**

(51) International Patent Classification (IPC):
***G03F 1/24*** *(2012.01)*

(21) Application number: **24176894.4**

(52) Cooperative Patent Classification (CPC):
**G03F 1/24**

(22) Date of filing: **20.05.2024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.05.2023 JP 2023087134**

(71) Applicant: SHIN-ETSU CHEMICAL CO., LTD.
**Tokyo (JP)**

(72) Inventors:
• SUGIYAMA, Tomoaki
  Joetsu-shi (JP)
• HARADA, Daijitsu
  Joetsu-shi (JP)
• MATSUI, Harunobu
  Joetsu-shi (JP)
• TAKEUCHI, Masaki
  Joetsu-shi (JP)

(74) Representative: **Mewburn Ellis LLP**
**Aurora Building**
**Counterslip**
**Bristol BS1 6BX (GB)**

(54) **MASK BLANK SUBSTRATE AND MANUFACTURING METHOD THEREOF**

(57) A mask blank substrate has first and second main surfaces of 152 mm×152 mm-square and 6.35 mm-thick , in which in a pseudo TTV map obtained by adding up maps of the first and second main surfaces, a difference between highest and lowest heights of a TTV1 map, is ≤35 nm, excluding a primary component when a plane function is derived, and a difference between highest and lowest heights of a TTV2 map, is ≤25 nm, excluding primary and secondary components when a curved-surface function is derived, in fitting of the pseudo TTV map within a cross-shaped region formed in a case where a first rectangular region is overlapped with a second rectangular region, the first and second rectangular regions of 132 mm×104 mm being orthogonal to each other, and parallel to four sides of the main surfaces centered at intersections of diagonal lines of the main surfaces.

# FIG.1B

**Description**

TECHNICAL FIELD

The present invention relates to a mask blank substrate used for photolithography and a manufacturing method thereof, and more particularly to a mask blank substrate suitable for mask blanks used for manufacturing a transfer mask for the photolithography in which extreme ultra violet (EUV) light is used for exposure light and a manufacturing method thereof.

BACKGROUND

In recent years, as AI and IoT attract attention, arithmetic processing of enormous data has become necessary, and accordingly, speeding up of the arithmetic processing and power saving have been required. In order to meet these demands, it is necessary to improve performance of an IC chip, and in general, miniaturization of electrical wiring is adopted as an effective method. For the miniaturization of the wiring, high NA, the exposure light having a short wavelength, and the like are mainly adopted, but in recent years, extreme ultraviolet (EUV) lithography (EUVL) using the EUV light has been put to practical use.

In the EUVL, an exposure mask is one of important elements, and it is extremely important to improve a flatness of a glass substrate for an original plate (the mask blanks) of the exposure mask in order to implement accurate exposure. As a normal manufacturing method of the glass substrate, double-sided simultaneous polishing is mainly used, but a flatness that is good enough to be used for the EUVL cannot be obtained by only the double-sided simultaneous polishing. In order to achieve a high flatness, it is necessary to modify the flatness according to a surface shape by polishing one side at a time, and a local processing technique such as local etching or local polishing is used for this purpose. These are methods for making the entire substrate nearly flat by removing a relatively convex region on a main surface of the substrate. In addition, using a wavefront correction function of an exposure apparatus can optically correct a surface shape of the exposure mask, and the exposure mask can be optically high in the flatness.

With a recent trend toward the miniaturization, the EUVL has also been required to have the high NA, and flatness requirements are becoming increasingly strict. The flatness requirements have reached a range that cannot be achieved only by pursuing a polishing technique, and it has been required to selectively manufacture the glass substrate having a shape that can be used for exposure rather than using the flatness merely as an index.

Examples of the index deeply related to such performance include TTV of the glass substrate. The TTV has been used for performance evaluation of a single-component glass substrate. A transmission optical system is suitable for measuring a substrate thickness distribution (a TTV map), and it was easy to measure the TTV map of the single-component glass. However, in a multi-component glass substrate used for the EUVL, a refractive index distribution caused by fluctuation of a glass component concentration occurs, and it was difficult to measure the TTV map in an optically precise manner. Therefore, it was necessary to use a simulated TTV map (hereinafter, a pseudo TTV map) obtained by adding up surface shapes of a first main surface and a second main surface, respectively.

For example, in WO 2016/098452 (Patent Document 1), in order to obtain a high transfer accuracy when a reflective mask prepared by using a substrate having both front and back main surfaces subjected to a conventional double-sided polishing and a local processing is chucked to the exposure apparatus to perform the exposure transfer, if a shape of the front main surface of the substrate during electrostatic chuck is made close to a shape that can be defined by a Zernike polynomial correctable by the wavefront correction function of the exposure apparatus (a virtual surface shape), a substrate thickness variation can tend to be easily corrected by the wavefront correction function of the exposure apparatus, even if the substrate has the substrate thickness variation that affects a change in the shape of the front main surface, and with the transfer mask having such substrate, a transfer pattern can be exposed and transferred onto a transfer target in a high precise manner.

Citation List

Patent Document 1: WO 2016/098452
Patent Document 2: JP-A 2010-194705

SUMMARY OF THE INVENTION

A method described in WO 2016/098452 (Patent Document 1) includes a process of calculating a synthesis plane of the front main surface and the back main surface during attraction to the exposure apparatus, a process of fitting the synthesis plane with the Zernike polynomial, and a process of subtracting a fitting shape from the synthesis plane to predict the surface shape after an optical correction. However, this method defines the flatness in a circular region having a diameter of 104 mm, and is insufficient for a region actually used for the exposure (132 mm × 104 mm square). Further, a steep shape of an outermost circumference tends to be intensively corrected by excluding relatively high-order terms from a fourth item to a sixth item of a Legendre polynomial. In such case, the correction is applied to shapes that would otherwise have an adverse effect on the exposure, so that the TTV is evaluated as good.

The present invention has been made in view of the above circumstances, and aims to provide the mask blank substrate that provides an exposure mask capable of achieving the transfer accuracy extremely advantageous for next generation high-NA EUV exposure during the exposure using the exposure mask, particularly, the exposure due to the EUVL, and a method capable of manufacturing such mask blank substrate with high productivity.

As a result of intensive studies to solve the above problems, the present inventors have found that, the mask blank substrate having two main surfaces of a first main surface and a second main surface of 152 mm × 152 mm square, and a thickness of 6.35 mm, becomes sufficiently high in the flatness during electrostatic attraction of an exposure machine and can provide the exposure mask having a good transfer performance, in which when a cross-shaped region is set that is formed in a case where the pseudo TTV map is created by adding up height maps of the first main surface and the second main surface, and a first rectangular region of 132 mm × 104 mm is overlapped with a second rectangular region of 104 mm × 132 mm in the pseudo TTV map, the first rectangular region being parallel to four sides of the main surfaces centered at intersections of diagonal lines of the main surfaces, and the second rectangular region being orthogonal to the first rectangular region and parallel to the four sides of the main surfaces centered at the intersections of the diagonal lines of the main surfaces, a difference (TTV1) between a highest height and a lowest height of a TTV1 map, is 35 nm or less, excluding a primary component when a plane function approximated by a first-order polynomial is derived in the fitting of the pseudo TTV map, and a difference (TTV2) between a highest height and a lowest height of a TTV2 map, is 25 nm or less, excluding a primary component and a secondary component when a curved-surface function approximated by up to a second-order polynomial is derived in the fitting of the pseudo TTV map within the cross-shaped region.

In addition, the present inventors have found that it is possible to reliably and productively manufacture the mask blank substrate which is sufficiently flat during the electrostatic adsorption of the exposure machine and provides the exposure mask having the good transfer performance by manufacturing the mask blank substrate by a method including a local processing step and a finish polishing step subsequent to the local processing step, predicting the shapes of the main surfaces after the finish polishing step by applying changes in the shapes of the main surfaces after the finish polishing step grasped in advance after the local processing step to the shapes of the main surfaces before the finish polishing step in the local processing step, and evaluating whether or not the predicted shapes of the main surfaces are shapes that impart a predetermined flatness, and have completed the present invention.

Therefore, the present invention provides the following mask blank substrate and the manufacturing method of the mask blank substrate.

1. A mask blank substrate having two main surfaces of a first main surface and a second main surface of 152 mm × 152 mm square and a thickness of 6.35 mm, in which

in a pseudo TTV map obtained by adding up a height map of the first main surface and a height map of the second main surface based on a position of each of the first main surface and the second main surface on a respective least-square plane,
a difference (TTV1) between a highest height and a lowest height of a TTV1 map, is 35 nm or less, excluding a primary component when a plane function approximated by a first-order polynomial is derived in fitting of the pseudo TTV map, and a difference (TTV2) between a highest height and a lowest height of a TTV2 map, is 25 nm or less, excluding a primary component and a secondary component when a curved-surface function approximated by up to a second-order polynomial is derived in the fitting of the pseudo TTV map, within a cross-shaped region formed in a case where a first rectangular region of 132 mm × 104 mm is overlapped with a second rectangular region of 104 mm × 132 mm, the first rectangular region being parallel to four sides of the main surfaces of the substrate centered at intersections of diagonal lines of the main surfaces of the substrate, and the second rectangular region being orthogonal to the first rectangular region and parallel to the four sides of the main surfaces of the substrate centered at the intersections of the diagonal lines of the main surfaces of the substrate.

2. The mask blank substrate according to 1, in which a flatness of the first main surface within the cross-shaped region is 35 nm or less.

3. A manufacturing method of a mask blank substrate having two main surfaces of a first main surface and a second main surface of 152 mm × 152 mm square and a thickness of 6.35 mm, the manufacturing method including:

a local processing step for at least one of the first main surface and the second main surface, and a finish polishing step subsequent to the local processing step, in which
the local processing step includes:

(A) a step of locally processing the at least one of the first main surface and the second main surface;
(B) a step of measuring a shape of the main surface locally processed after step (A) as the shape of the main surface before the finish polishing step;
(C) a step of predicting the shape after the finish polishing step of the main surface locally processed, by applying a change in a surface shape in a finish polishing step grasped in advance to the shape of the main surface obtained in step (B) before the finish polishing step; and
(D) a step of evaluating whether or not the shape after the finish polishing step predicted in step (C) is a shape giving a predetermined TTV.

4. The manufacturing method according to 3, in which the shape giving the predetermined TTV in step (D) is a shape where in a predicted pseudo TTV map within a cross-shaped region formed in a case where:

(1) the first main surface and the second main surface of the substrate are arranged along a substantially vertical direction, and a calculation region in a regular square tubular shape is set that extends in a horizontal direction through four sides of a square of 132 mm × 132 mm along four sides of the first main surface and the second main surface in central portions of the first main surface and the second main surface;
(2) a portion of the first main surface within the calculation region is cut out in a state of facing the first main surface as a first region face;
(3) a vertical face is set that passes through a reference point which is one arbitrary point on a central axis of a regular square cylinder in the calculation region and is orthogonal to the central axis as a reference plane, a rotation axis is set that passes through the reference point and is parallel to any one side of four sides of a regular square, which is one intersection line between the regular square cylinder in the calculation region and the vertical face, and a portion of the second main surface within the calculation region is cut out in a state of facing the second main surface by rotating the substrate by 180 degrees along the rotation axis from the state of facing the first main surface as a second region face;
(4) a least-square plane is calculated in each of the first region face and the second region face;
(5) the first region face and the second region face are converted into a height map of the first region face and a height map of the second region face based on a position of each of the first region face and the second region face on a respective least-square plane;
(6) the height map of the second region face is set as an inverted height map of the second region face by symmetrically moving the height map with respect to a perpendicular face passing through the rotation axis and along a 90 degree direction of the rotation;
(7) a predicted pseudo TTV map is created by adding up a height of the height map of the first region face and a height of the inverted height map of the second region face at the position (a X coordinate, Y coordinate) on the respective reference plane; and
(8) a first rectangular region of 132 mm × 104 mm is overlapped with a second rectangular region of 104 mm × 132 mm in the predicted pseudo TTV map, the first rectangular region being parallel to the four sides of the main surfaces of the substrate centered at intersections of diagonal lines of the main surfaces of the substrate, and the second rectangular region being orthogonal to the first rectangular region and parallel to the four sides of the main surfaces of the substrate centered at the intersections of the diagonal lines of the main surfaces of the substrate,

a difference (TTV1') between a highest height and a lowest height of a TTV1' map, is 35 nm or less, excluding a primary component when a plane function approximated by a first-order polynomial is derived in fitting of the predicted pseudo TTV map, and a difference (TTV2') between a highest height and a lowest height of a TTV2' map, is 25 nm or less, excluding a primary component and a secondary component when a curved-surface function approximated by a second-order polynomial is derived in the fitting of the predicted pseudo TTV map.

ADVANTAGEOUS EFFECTS

The mask blank substrate of the present invention can provide the exposure mask having a highly flat shape when the exposure mask is electrostatically attracted to the exposure apparatus during the exposure using the exposure mask, particularly, the exposure due to the high-NA EUVL. In addition, according to the manufacturing method of the mask blank substrate of the present invention, such mask blank substrate can be reliably manufactured with high productivity.

BRIEF DESCRIPTION OF THE DRAWINGS

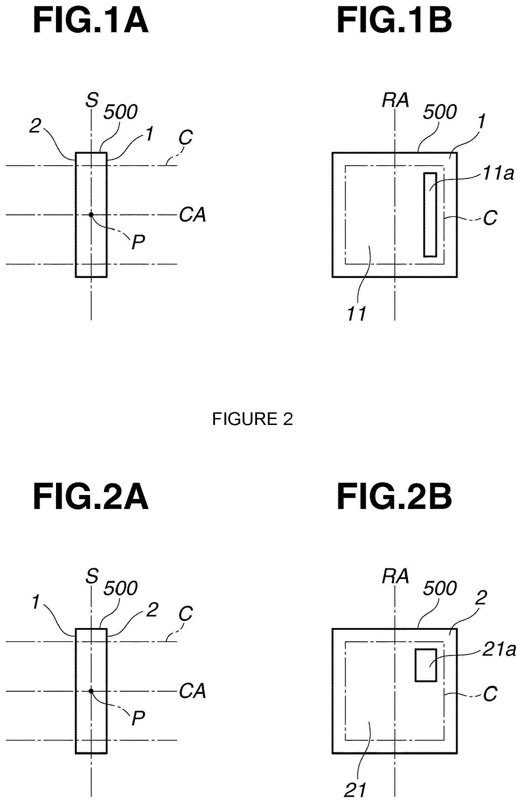

FIGS. 1A and 1B are views for explaining an aspect of a mask blank substrate of the present invention, in which FIG. 1A is a side view of a state where a first main surface and a second main surface of the mask blank substrate are arranged along the vertical direction, and FIG. 1B is a front view of the first main surface located on a right side in FIG. 1A;
FIGS. 2A and 2B are views for explaining an aspect of the mask blank substrate of the present invention, in which FIG. 2A is a side view of the mask blank substrate after rotation by 180 degrees, and FIG. 2B is a front view of the second main surface located on a right side in FIG. 2A after the rotation;

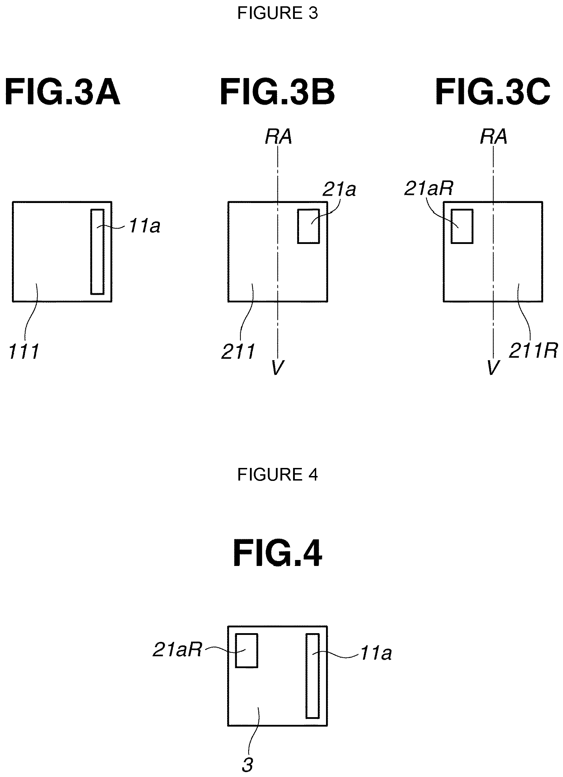

FIGS. 3A to 3C are views for explaining an aspect of the mask blank substrate of the present invention, in which FIG. 3A is a height map of a first region face, FIG. 3B is a height map of a second region face, and FIG. 3C is an inverted height map of the second region face;
FIG. 4 is a view for explaining an aspect of the mask blank substrate of the present invention, and is a pseudo TTV map (a map of a Z coordinate) obtained from the height map of the first region face and the inverted height map of the second region face; and

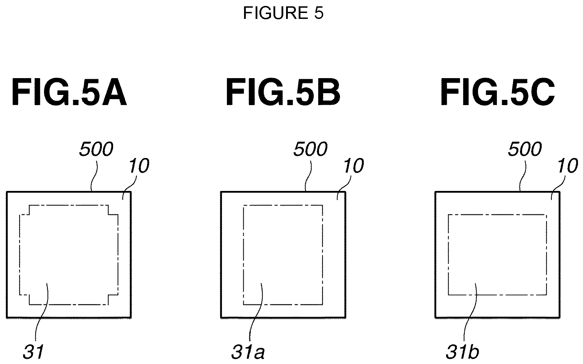

FIGS. 5A to 5C are views for explaining an aspect of the mask blank substrate of the present invention, in which FIG. 5A is a view illustrating a cross-shaped region that is a target region for evaluation in the pseudo TTV map, FIG. 5B is a view illustrating a first rectangular region (a vertically long region) constituting the cross-shaped region, and FIG. 5C is a view illustrating a second rectangular region (a horizontally long region) constituting the cross-shaped region.

FURTHER EXPLANATIONS; OPTIONS AND PREFERENCES

Hereinafter, the present invention is described in detail.

The mask blank substrate of the present invention has the two main surfaces of the first main surface and the second main surface of 152 mm × 152 mm square, and the thickness of 6.35 mm. The substrate of this size is referred to as a so-called 6025 substrate, and is a substrate having the two main surfaces of the first main surface and the second main surface of 6 inches × 6 inches square and a thickness of 0.25 inches.

A material of the mask blank substrate of the present invention may be a conventionally used material, and is not particularly limited. However, in drawing of a fine pattern, the substrate is exposed to high-energy exposure light, and thus $TiO_2$-doped quartz glass containing 3 to 10 wt% of $TiO_2$, which has a very high dimensional stability at a high temperature, is suitably used. As a raw material substrate of the mask blank substrate, a substrate synthesized, molded, and processed according to a conventional method can be used.

The mask blank substrate is required to have a high flatness. This is because the higher the flatness, the easier it is to achieve target exposure, and it can be said that the substrate having the higher flatness is the mask blank substrate suitable for the drawing of the fine pattern. The mask blank substrate has the first main surface on which an exposure pattern (such as a wiring pattern) is formed after film formation and the second main surface on which no exposure pattern is formed, and the second main surface is attracted to and held by the exposure machine. Among them, in the most advanced applications, the flatness of the first main surface is required at an extremely high level, since a reflective mask is mainly used. Therefore, in order to improve the flatness of the first main surface, various studies have been made on flattening according to the local processing technique.

On the other hand, there is a wavefront correction function as a function on the exposure machine side. This is a function for optically correcting the surface shape even for a substrate having a low flatness, and accordingly, even a substrate having an actually low flatness attains an exposure result equivalent to that of the substrate having the high flatness.

In the pseudo TTV map obtained by adding up the height map of the first main surface and the height map of the second main surface based on the position of the each of the first main surface and the second main surface on the respective least-square plane, the mask blank substrate of the present invention has the difference (TTV1) of 35 nm or less between the highest height and the lowest height of the TTV map excluding the primary component, and the difference (TTV2) of 25 nm or less between the highest height and the lowest height of the TTV map excluding the primary component and the secondary component within the cross-shaped region formed in the case where the first rectangular region of 132 mm × 104 mm is overlapped with the second rectangular region of 104 mm × 132 mm, the first rectangular region being parallel to the four sides of the main surfaces of the substrate centered at the intersections of the diagonal lines of the main surfaces of the substrate, and the second rectangular region being orthogonal to the first rectangular region and parallel to the four sides of the main surfaces of the substrate centered at the intersections of the diagonal lines of the main surfaces of the substrate.

Specifically, it is preferable that in the mask blank substrate of the present invention,

the difference (TTV1) between the highest height and the lowest height of the TTV1 map excluding the primary component is 35 nm or less, and the difference (TTV2) between the highest height and the lowest height of the TTV2 map excluding the primary component and the secondary component is of 25 nm or less, in the pseudo TTV map within the cross-shaped region formed in the case where:

(1) the first main surface and the second main surface of the substrate are arranged along the substantially vertical direction, and the calculation region in the regular square tubular shape is set that extends in the horizontal direction through the four sides of the square of 132 mm $\times$ 132 mm along the four sides of the first main surface and the second main surface in the central portions of the first main surface and the second main surface;

(2) the portion of the first main surface within the calculation region is cut out in the state of facing the first main surface as the first region face;

(3) the vertical face is set that passes through the reference point which is the one arbitrary point on the central axis of the regular square cylinder in the calculation region and is orthogonal to the central axis as the reference plane, the rotation axis is set that passes through the reference point and is parallel to any one side of the four sides of the regular square that is the intersection line between the regular square cylinder in the calculation region and the vertical face, and the portion of the second main surface within the calculation region is cut out in the state of facing the second main surface by rotating the substrate by 180 degrees along the rotation axis from the state of facing the first main surface as the second region face;

(4) the least-square plane is calculated in the each of the first region face and the second region face;

(5) the first region face and the second region face are converted into the height map of the first region face and the height map of the second region face based on the position of the each of the first region face and the second region face on the respective least-square plane;

(6) the height map of the second region face is set as the inverted height map of the second region face by symmetrically moving the height map with respect to the perpendicular face passing through the rotation axis in (3) and along the 90 degree direction of the rotation in (3);

(7) the pseudo TTV map is created by adding up the height of the height map of the first region face and the height of the inverted height map of the second region face at the position (the X coordinate, the Y coordinate) on the respective reference plane; and

(8) the first rectangular region of 132 mm $\times$ 104 mm is overlapped with the second rectangular region of 104 mm $\times$ 132 mm in the pseudo TTV map, the first rectangular region being parallel to the four sides of the main surfaces of the substrate centered at the intersections of the diagonal lines of the main surfaces of the substrate, and the second rectangular region being orthogonal to the first rectangular region and parallel to the four sides of the main surfaces of the substrate centered at the intersections of the diagonal lines of the main surfaces of the substrate.

The above (1) to (8) is specifically described with reference to FIGS. 1A and 1B to 4 for explaining the aspects of the mask blank substrate of the present invention. First, in FIGS. 1A and 1B, FIG. 1A is the side view of the state where the first main surface and the second main surface of the mask blank substrate are arranged along the vertical direction, and FIG. 1B is the front view of the first main surface located on the right side in FIG. 1A. In (1), as illustrated in FIG. 1A, a first main surface 1 and a second main surface 2 of 152 mm $\times$ 152 mm square of a substrate 500 are arranged substantially along the vertical direction, and a calculation region C in the regular square tubular shape is set that extends in the horizontal direction through four sides of a square of 132 mm $\times$ 132 mm along four sides of the first main surface 1 and the second main surface 2 in central portions of the first main surface 1 and the second main surface 2.

Next, in (2), as illustrated in FIG. 1B, a portion of the first main surface 1 within the calculation region C is cut out in a state of facing the first main surface 1 as a first region face 11. Here, for convenience, it is assumed that there is a convex portion 11a on the first main surface 1, and there is also a convex portion 21a on the second main surface 2 as illustrated in FIG. 2B to be described later.

Next, in (3), as illustrated in FIGS. 1A and 1B, a vertical face that passes through a reference point P, which is one arbitrary point on a central axis CA of a regular square cylinder in the calculation region C and is orthogonal to the central axis CA, is set as a reference plane S (here, the reference plane S is a face extending in a depth direction of the drawing), and a rotation axis RA is set that passes through the reference point P and is parallel to any one side of four sides of a regular square, which is an intersection line between the regular square cylinder in the calculation region C and the vertical face. Then, the substrate 500 is rotated by 180 degrees along the rotation axis RA (around the rotation axis RA) from a state of facing the first main surface 1.

On the other hand, in FIGS. 2A and 2B, FIG. 2A is a side view of the mask blank substrate after the rotation by 180 degrees, and FIG. 2B is a front view of the second main surface located on the right side in FIG. 2A after the rotation. After the rotation of the substrate 500, as illustrated in FIG. 2B, a portion of the second main surface 2 within the calculation region C is cut out in a state of facing the second main surface 2 as a second region face 21.

Next, in (4), a least-square plane is calculated in each of the first region face 11 and the second region face 21, and in (5), the first region face 11 and the second region face 21 are converted into a height map 111 of the first region face as illustrated in FIG. 3A and a height map 211 of the second region face as illustrated in FIG. 3B based on a position of each of the first region face 11 and the second region face 21 on a respective least-square plane as a reference. In addition, in (6), the height map 211 of the second region face is moved symmetrically with respect to a perpendicular face V (here, the perpendicular face V is a plane extending in the depth direction of the drawing) that passes through the rotation axis RA in (3) and is along a 90 degree rotation direction in (3) as illustrated in FIG. 3B, and is set as an inverted height map 211R of the second region face as illustrated in FIG. 3C. Note that, since the inverted height map 211R of the second region face illustrated in FIG. 3C is obtained by symmetrically moving the height map 211, 21aR in the inverted height map 211R is not inverted in a height direction and is a protrusion similarly to 21a.

Next, in (7), the height map 111 of the first region face illustrated in FIG. 3A is overlapped with the inverted height map 211R of the second region face illustrated in FIG. 3C, and a height of the height map 111 of the first region face and a height of the inverted height map 211R of the second region face are added up at each position (an X coordinate, a Y coordinate) on the reference plane S illustrated in FIG. 1A to create a pseudo TTV map (a map of a Z coordinate) 3 as illustrated in FIG. 4.

Next, in (8), in the pseudo TTV map obtained in (7), a cross-shaped region 31 illustrated in FIG. 5A is cut out to evaluate parameters (TTV1 and TTV2) obtained by numerical processing of pseudo TTVs of the pseudo TTV map within the cross-shaped region 31, in which the cross-shaped region is formed in a case where a first rectangular region (a vertically long region) 31a of 132 mm × 104 mm is overlapped with a second rectangular region (a horizontally long region) 31b of 104 mm × 132 mm. The first rectangular region is parallel to four sides of a main surface (the first main surface or the second main surface) 10 of the substrate 500 centered at an intersection of a diagonal line of the main surface of the substrate illustrated in FIG. 5B, and the second rectangular region is orthogonal to the first rectangular region 31a and parallel to the four sides of the main surface (same main surface) 10 of the substrate 500 centered at the intersection of the diagonal line of the main surface of the substrate, illustrated in FIG. 5C.

A minimum region on the main surface of the substrate that may be used for the exposure is the first rectangular region of 132 mm × 104 mm parallel to the four sides of the main surface of the substrate centered at the intersection of the diagonal lines of the main surface and the second rectangular region of 104 mm × 132 mm parallel to the four sides of the main surface of the substrate centered at the intersection of the diagonal lines of the main surface of the substrate, and it is effective for the pseudo TTV map to target the cross-shaped region in which both of the rectangular regions are overlapped with each other. Therefore, in the present invention, the cross-shaped region is set as a target region for evaluation.

In the present invention, the TTVs are used as an index of the shape of the mask blank substrate that can be efficiently used for the exposure in a multi-component glass substrate used for the EUVL. In the pseudo TTV map, the TTV1 calculated from the TTV1 map excluding the primary component that is a simple component and the TTV2 calculated from the TTV2 map excluding the primary component and the secondary component that are slightly complicated components are important indices that greatly affect exposure performance. In the fitting of the pseudo TTV map, when the plane function (specifically, a function represented by the following expression (1)) approximated by the first-order polynomial or the curved-surface function (specifically, a function represented by the following expression (2)) approximated by up to the second-order polynomial are derived, a linear function component is the primary component, and a quadratic function component is the secondary component.

Here, a method of calculating the TTV1 and the TTV2 is described. First, a pseudo TTV map ($S_{TTV}$) is created with a center of the substrate as an origin, a horizontal axis as x [mm], a vertical axis as y [mm], and the height direction as z [nm]. Next, the pseudo TTV map is approximated by the following expressions (1) and (2).

$$S'_{TTV1} = a_1 x + a_2 y \qquad (1)$$

$$S'_{TTV2} = b_1 x + b_2 y + b_3 x^2 + b_4 xy + b_5 y^2 \qquad (2)$$

In the expression, $a_1$, $a_2$, $b_1$, $b_2$, $b_3$, $b_4$, and $b_5$ are all constants. Approximate expressions S' ($S'_{TTV1}$ and $S'_{TTV2}$) are subtracted from the pseudo TTV map ($S_{TTV}$) as in the following expressions (3) and (4) as the TTV1 map ($S_{TTV1}$) and the TTV2 map ($S_{TTV2}$).

$$S_{TTV1} = S_{TTV} - S'_{TTV1} \qquad (3)$$

$$S_{TTV2} = S_{TTV} - S'_{TTV2} \qquad (4)$$

Then, the difference between the highest height and the lowest height of the TTV1 map ($S_{TTV1}$) is defined as TTV1 and the difference between the highest height and the lowest height of the TTV2 map ($S_{TTV2}$) is defined as TTV2.

The steeper the shape of an outer periphery, the more likely it is to have a negative effect on the exposure. Such shape can be considered to be mainly composed of secondary or higher components. Accordingly, by excluding only the primary component and evaluating the TTV1 in which the secondary or higher component remains, it is possible to avoid exposure failure due to the steep shape of the outer periphery. In addition, the wavefront correction function of the exposure machine is usually well approximated by up to the secondary component. In other words, a substrate having a poor pseudo TTV calculated by excluding components up to the secondary component can be specified as a substrate that is difficult to be corrected by the wavefront correction function, and a substrate that is easy to be corrected by the wavefront correction function can be selected by evaluating the TTV2 excluding the primary component and the secondary component.

The measurement of the shapes of the main surfaces of the mask blank substrate is not particularly limited, but for example, a laser interferometer can be used. The shapes that can be measured by the laser interferometer are raw data of the height maps of the main surfaces of the substrate, and in this case, a height reference is a platform on which the substrate is placed during the measurement. In the present invention, in regards to the height maps of the main surfaces of the substrate, the least-square planes of the main surfaces (the least-square planes of the surfaces or the height maps) are calculated and corrected to the height maps based on the least-square planes, whereby the influence due to a shape of the platform on which the substrate is placed can be removed.

Among the height maps corrected in this manner, the inverted height map of the second region face, which is obtained by symmetrically moving the height map of the second region face with respect to a face passing through the rotation axis in (3) and along the 90 degree rotation direction in (3) as a reference, has both sides inverted in a direction orthogonal to the rotation axis in (3), although a positive side and the negative side in the height direction remain the same. The pseudo TTV map can be calculated by adding up the first main surface and the inverted height map of the second main surface so as to obtain the substrate thickness distribution of the mask blank substrate. Here, the pseudo TTVs are differences between a highest value (the highest height) and a lowest value (the lowest height) within a predetermined range.

For the pseudo TTVs of the mask blank substrate of the present invention, the difference (TTV1) between the highest height and the lowest height of the TTV1 map (the pseudo TTV1 map) excluding the primary component is 35 nm or less, preferably 30 nm or less, and more preferably 25 nm or less. If the TTV1 is 35 nm or less, such mask blank substrate is a mask blank substrate that can advantageously achieve exposure with a good transfer accuracy during the exposure using the exposure mask obtained from the mask blank substrate through the mask blank. On the other hand, if the TTV1 is larger than 35 nm, such mask blank substrate is disadvantageous in the transfer accuracy.

In addition, for the pseudo TTVs of the mask blank substrate of the present invention, the difference (TTV2) between the highest height and the lowest height of the TTV2 map (the pseudo TTV2 map) excluding the primary component and the secondary component is 25 nm or less, preferably 20 nm or less, and more preferably 18 nm or less. Such mask blank substrate is the mask blank substrate that can advantageously achieve the exposure with the good transfer accuracy during the exposure using the exposure mask obtained from the mask blank substrate through the mask blank.

TTV1 is calculated from the TTV1 map excluding the primary component in the pseudo TTV map, and the TTV1 can be said to be similar to the flatness. However, in the present invention, an upper limit (a threshold value) of the TTV2 calculated from the TTV2 map excluding (relaxing) the primary component and the secondary component in the pseudo TTV map is 25 nm or less. The TTV2 reflects an actual flatness during the exposure more than the TTV1, and the mask blank substrate having the TTV1 and the TTV2 within a predetermined range is a mask blank substrate that can achieve a good exposure when actually subjected to the exposure, and can provide a photomask blank having a high exposure performance.

Conventionally, for example, a range of 138 mm × 138 mm parallel to the four sides of the main surfaces of the substrate centered at the intersections of the diagonal lines of the main surfaces has been evaluated, but this range extends to a range including not only a region used for the exposure, but also the portions of the main surfaces on a side vacuum-attracted to the exposure apparatus, the portion being vacuum-attracted to the exposure apparatus. In the present invention, the cross-shaped region obtained by overlapping the two regions described above of 132 mm × 104 mm is set as a target for the evaluation. This cross-shaped region is a range narrower than a conventional range, but a range outside the cross-shaped region is a range that is not usually used for the exposure, and tends to have a high flatness.

Although the mask blank substrate of the present invention has the TTV1 of 35 nm or less and the TTV2 of 25 nm or less in the cross-shaped region described above, the mask blank substrate of the present invention can be applied not only to a conventional NA 0.33 generation but also to a NA 0.55 generation, which requires a more severe flatness, and can be suitably applied as a mask blank substrate for a next-generation EUV exposure apparatus.

In addition, at least one of the flatness of the first main surface in the cross-shaped region and the flatness of the second main surface in the cross-shaped region of the mask blank substrate of the present invention, preferably the flatness of the first main surface in the cross-shaped region when a side on which an optical film is formed is set as the first main surface and a side vacuum-attracted to the exposure apparatus is set as the second main surface, is preferably 35 nm or less, more preferably 20 nm or less, and still more preferably 18 nm or less. Such mask blank substrate is the mask blank substrate that can more advantageously achieve the exposure with the good transfer accuracy during the exposure using the exposure mask obtained from the mask blank substrate through the mask blank.

Next, the manufacturing method of the mask blank substrate of the present invention is described.

The manufacturing method of the mask blank substrate of the present invention includes the local processing step for at least one of the first main surface and the second main surface of the mask blank substrate, and the finish polishing step subsequent to the local processing step.

In the manufacturing of the mask blank substrate, the raw material substrate for the mask blank substrate is prepared from a glass ingot before the local processing step, but the raw material substrate for the mask blank substrate can be prepared by first cutting out the glass ingot into a predetermined shape, performing outer shape processing, and then polishing the main surfaces and end faces. The polishing can be performed in several stages such as rough polishing, precision polishing, and ultra-precision polishing. This polishing can be performed by using a polishing cloth and a polishing agent. The polishing agent is not particularly limited, but for example, an aqueous dispersion of cerium oxide having an average primary particle size of 10 to 100 nm, an aqueous dispersion of silica nanoparticles (a colloidal silica aqueous dispersion) having an average primary particle size of 10 to 100 nm, or the like can be used.

Each of the surface shapes obtained only by the local processing is not flat, and usually is a shape (in general, a middle convex shape (a shape with the center portion of each of the main surface protruding), a middle concave shape (a shape with the central portion of the each of the main surfaces recessed), or the like) that cancels changes in the surface shapes in the finish polishing performed thereafter. Even if the flatness of the each of the surface shape obtained only by the local processing is evaluated, the evaluation is only deviated from evaluation results of the shapes of the main surfaces of the mask blank substrate finally obtained. After the local processing, there is reproducibility in the changes in the shapes of the main surfaces caused by the finish polishing performed under a predetermined polishing condition. By understanding the changes in the shapes of the main surfaces after the finish polishing under the predetermined polishing condition, applying the changes to the shapes of the main surfaces after the local processing to predict the surface shapes after the finish polishing performed under the predetermined polishing condition, the surface shapes obtained after the finish polishing can be evaluated at a stage of the local processing before the finish polishing to evaluate qualities of the shapes of the main surfaces obtained by the finish polishing. Note that, the local processing step can be repeated until the predetermined shape is obtained.

In the manufacturing of the mask blank substrate of the present invention, the local processing step is preferred to include:

(A) the step of locally processing the at least one of the first main surface and the second main surface;
(B) the step of measuring the shape of the main surface locally processed after step (A) as the shape of the main surface before the finish polishing step;
(C) the step of predicting the shape of the main surface locally processed after the finish polishing step by applying the change in the surface shape in the finish polishing step grasped in advance to the shape of the main surface obtained in step (B) before the finish polishing step; and
(D) the step of evaluating whether or not the shape after the finish polishing step predicted in step (C) is the shape giving the predetermined TTV.

In the step (A), the main surface is locally processed, but in the local processing, a predetermined processing condition in the local processing is set such that the main surface has the predetermined shape in consideration of the shape of the main surface before the local processing and the change in the shape of the main surface in the finish polishing step. Specifically, for example, in a case where the main surface changes to be convex by the finish polishing, the main surface preferably has a shape (for example, a low convex or concave shape) that cancels the change in consideration of the change, and in a case where the main surface changes to be concave by the finish polishing, the main surface preferably has a shape (for example, a shallow concave or convex shape) that cancels the change in consideration of the change. Before the local processing, the shape of the main surface is appropriately measured, but this measurement is not particularly limited, and for example, the laser interferometer can be used.

In the local processing, processing for selectively removing a relatively convex portion is performed on the main surface of the mask blank substrate. The local processing can be performed by polishing with the polishing cloth and the polishing agent. The polishing agent is not particularly limited, but for example, the aqueous dispersion of the cerium oxide having the average primary particle size of 10 to 100 nm, the aqueous dispersion of the silica nanoparticles (the colloidal silica aqueous dispersion) having the average primary particle size of 10 to 100 nm, or the like can be used. In addition, in the local processing, a method such as Magneto-Rheological Finishing (MRF) can also be applied.

In step (B), the shape of the main surface after step (A), that is, actually after the local processing is measured as the shape of the main surface before the finish polishing step, but this measurement is not particularly limited, and for example, the laser interferometer can be used.

In step (C), the change in the surface shape in the finish polishing step grasped in advance is applied to the shape of the main surface obtained in step (B) before the finish polishing step to predict the shape of the main surface locally processed after the finish polishing step.

Specifically, the change in the shape of the surface before and after the finish polishing step of the main surface (the change in the surface shape after the finish polishing step with respect to the surface shape after local processing step) is grasped, but this change can be grasped, for example, from the shape of the main surface obtained by selecting another mask blank substrate having a main surface in a similar shape from the mask blank substrate subjected to the local processing and performing predetermined finish polishing on this another mask blank substrate. In addition, the change in the surface shape can also be grasped by simulation. In this case, as the another mask blank substrate, it is suitable to have the main surface in a middle-concave shape that is a target shape in the local processing step, and it is suitable to have the main surface with the flatness of less than 300 nm. The change in the surface shape grasped in advance in the finish polishing step is selected according to the shape of the main surface after the local processing obtained in step (B).

Here, for example, in a case where a shape of the pseudo TTV map of the main surface after the local processing step of the main surface is set as S 1 and a change in the shape of the pseudo TTV map of the main surface when the predetermined finish polishing is performed is set as $\Delta S$, according to the following expression

$$S1 + \Delta S = S2,$$

the shape of the main surface locally processed after the finish polishing step can be predicted as a shape (S2) of the pseudo TTV map (the predicted pseudo TTV map) of the main surface after the finish polishing step.

In step (D), it is evaluated whether the shape after the finish polishing step predicted in step (C) is the shape that imparts the predetermined flatness, specifically, the shape that gives the predetermined TTV. As an evaluation method, a method of measuring the shape of the main surface and evaluating a predetermined value calculated from the shape measured or a predetermined value obtained by mathematically processing the shape measured, can be used.

In step (D), for example, in the pseudo TTV map obtained by adding up the height map of the first main surface and the height map of the second main surface based on the position of the each of the first main surface and the second main surface of the mask blank substrate on the respective least-square plane, it can be evaluated whether or not the difference (TTV1) between the highest height and the lowest height of the TTV1 map (the pseudo TTV1 map) excluding the primary component is 35 nm or less, and the difference (TTV2) between the highest height and the lowest height of the TTV2 map (the pseudo TTV2 map) excluding the primary component and the secondary component is 25 nm or less within the cross-shaped region formed in the case where the first rectangular region of 132 mm × 104 mm is overlapped with the second rectangular region of 104 mm × 132 mm, the first rectangular region being parallel to the four sides of the main surfaces of the substrate centered at the intersections of the diagonal lines of the main surfaces of the substrate, and the second rectangular region being orthogonal to the first rectangular region and parallel to the four sides of the main surfaces of the substrate centered at the intersections of the diagonal lines of the main surfaces of the substrate.

Specifically, in step (D):
it can be evaluated whether or not the difference (TTV1') between the highest height and the lowest height of the TTV1' map (the predicted pseudo TTV1' map) excluding the primary component is 35 nm or less, and the difference (TTV2') between the highest height and the lowest height of the TTV2' map (the predicted pseudo TTV2' map) excluding the primary component and the secondary component is 25 nm or less in the predicted pseudo TTV map within the cross-shaped region formed in the case where:

(1) the first main surface and the second main surface of the substrate are arranged along the substantially vertical direction, and the calculation region in the regular square tubular shape is set that extends in the horizontal direction through the four sides of the square of 132 mm × 132 mm along the four sides of the first main surface and the second main surface in the central portions of the first main surface and the second main surface;
(2) the portion of the first main surface within the calculation region is cut out in the state of facing the first main surface as the first region face;
(3) the vertical face is set that passes through the reference point which is the one arbitrary point on the central axis of the regular square cylinder in the calculation region and is orthogonal to the central axis as the reference plane, the rotation axis is set that passes through the reference point and is parallel to any one side of the four sides of the regular square, which is the intersection line between the regular square cylinder in the calculation region and the vertical face, and the portion of the second main surface within the calculation region is cut out in the state of facing the second main surface by rotating the substrate by 180 degrees along the rotation axis from the state of facing the first main surface as the second region face;

(4) the least-square plane is calculated in the each of the first region face and the second region face;

(5) the first region face and the second region face is converted into the height map of the first region face and the height map of the second region face based on the position of the each of the first region face and the second region face on the respective least-square plane;

(6) the height map of the second region face is set as the inverted height map of the second region face by symmetrically moving the height map with respect to the perpendicular face passing through the rotation axis in (3) and along the 90 degree direction of the rotation in (3);

(7) the predicted pseudo TTV map is created by adding up the height of the height map of the first region face and the height of the inverted height map of the second region face at the position (the X coordinate, the Y coordinate) on the respective reference plane; and

(8) the first rectangular region of 132 mm × 104 mm is overlapped with the second rectangular region of 104 mm × 132 mm in the predicted pseudo TTV map, the first rectangular region being parallel to the four sides of the main surfaces of the substrate centered at the intersections of the diagonal lines of the main surfaces of the substrate, and the second rectangular region being orthogonal to the first rectangular region and parallel to the four sides of the main surfaces of the substrate centered at the intersections of the diagonal lines of the main surfaces of the substrate.

In step (D), in a case where the shape of the main surface predicted in step (C) is the shape having the predetermined flatness, it is possible to proceed to the finish polishing step. On the other hand, in step (D), in a case where the shape does not have the predetermined flatness, the local processing step, specifically, the local processing step including steps (A) to (D) can be performed again, and the local processing step, specifically, the local processing step including steps (A) to (D) can be repeated until the shape of the main surface predicted in step (C) is evaluated as the shape having the predetermined flatness in step (D).

Defect levels of the surfaces obtained only by the local processing may not be sufficient particularly in a mask blank substrate for state-of-the-art products, and in the manufacturing of the mask blank substrate, the finish polishing step is generally performed following the local processing step. Also in the manufacturing method of the mask blank substrate of the present invention, the finish polishing step is performed following the local processing step. The measurement of the shapes of the main surfaces of the mask blank substrate obtained after the finish polishing step is not particularly limited either, but for example, the laser interferometer can be used. As for the shapes of the main surfaces of the mask blank substrate obtained after the finish polishing, the pseudo TTV map can be created as necessary to evaluate the difference (TTV1) between the highest height and the lowest height of the TTV1 map and the difference (TTV2) between the highest height and the lowest height of the TTV2 map.

For example, if the local processing is generally repeated about twice, it is relatively easy to obtain the mask blank substrate having a TTV1 of about 100 nm, but in a conventional method, it is difficult to set the TTV1 to 35 nm or less and the TTV2 to 25 nm or less in the cross-shaped region described above.

According to the present invention, it is possible to provide the mask blank substrate high in flatness during the exposure of the exposure mask obtained by film formation and pattern formation on the mask blank substrate, and it is possible to manufacture such mask blank substrate with high productivity by evaluating the TTV with the pseudo TTV map. Further, the flatness of the mask blank substrate after the finish polishing can be estimated as the predicted pseudo TTV map by evaluating the TTV with the pseudo TTV map, and thus, the pseudo TTV map of the mask blank substrate after the finish polishing can be evaluated by the predicted pseudo TTV map to provide the mask blank substrate having a good flatness.

According to the present invention, it is also possible to evaluate whether or not the flatness during the exposure of the exposure mask obtained by the film formation and the pattern formation on the mask blank substrate is good by the pseudo TTV map of the mask blank substrate after the finish polishing.

<u>EXAMPLES</u>

Hereinafter, the present invention is specifically described with reference to Examples and Comparative Examples, but the present invention is not limited to the following Examples.

<u>Example 1</u>

Six glass substrates (sizes of first main surfaces and second main surfaces of 152 mm × 152 mm square, and a thickness of 6.35 mm) made from $SiO_2$ and $TiO_2$ ($TiO_2$ concentration of about 7 wt%) were prepared. End faces (four faces other than the main surfaces) of each of the glass substrates were subjected to chamfering processing and grinding processing, and further, the two main surfaces were subjected to the rough polishing and the precision polishing with a polishing solution containing cerium oxide abrasive grains. Thereafter, the six glass substrates (a substrate 1-1 to a substrate 1-6) were set on a carrier of a double-side polishing apparatus to which a soft polishing cloth of a suede type was applied, and the first main surfaces and the second main surfaces were subjected to the ultra-precision polishing by using a polishing solution of colloidal silica abrasive grains. After the ultra-precision polishing, the silica nanoparticles were removed by washing the main surfaces with a washing solution containing KOH, and after drying, the shapes of the first main surfaces and the second main surfaces were measured with a surface shape measurement apparatus (UltraFlat, manufactured by Tropel Corporation).

Next, the local processing step was performed. First, processing conditions for the local processing were determined on a basis of the shapes of the main surfaces obtained, and the first main surfaces and the second main surfaces of the glass substrates were locally processed by a local processing apparatus based on the processing conditions determined (step (A)). As the local processing apparatus, a local processing apparatus described in JP-A 2010-194705 (Patent Document 2) was used. The local processing using this apparatus polishes all the surfaces of the substrates while controlling a moving speed of a fine polishing tool, and target shapes can be obtained by slowly moving the polishing tool on a relatively convex portion and rapidly moving the polishing tool on a relatively concave portion. As a processing tool of the local processing apparatus, a wool felt buff was used, and as a polishing slurry, silica nanoparticles (AJ-3540, manufactured by Nissan Chemical Corporation) mixed with a small amount of a defoaming agent (Shin-Etsu Silicone KS-537, manufactured by Shin-Etsu Chemical Co., Ltd.) were used.

The glass substrates after the local processing were washed with the washing solution containing the KOH to remove the silica nanoparticles, dried, and then the shapes of the first main surfaces and the second main surfaces were measured with the surface shape measurement apparatus (UltraFlat, manufactured by Tropel Corporation) (step (B)).

Here, in order to grasp the changes in the shapes of the main surfaces after the finish polishing with respect to the surfaces after the local processing, another glass substrate was used, similarly, subjected up to the local processing, further, subjected to the finish polishing similar to the finish polishing to be described later to grasp the changes in the shapes of the surfaces before and after the finish polishing step in advance. Thereafter, for the six glass substrates (the substrates 1-1 to a substrate 1-6) after the local processing, the shapes of the surfaces after the finish polishing were predicted by applying the changes grasped in the shapes of the main surfaces to the shapes of the main surfaces of the glass substrates after the local processing (step (C)).

Next, it was evaluated whether or not the predicted shapes after the finish polishing step were shapes that give the predetermined TTV (step (D)). The shapes of the surfaces of the glass substrates after the local processing and the shapes of the surfaces predicted after the finish polishing were evaluated in cross-shaped regions formed in a case where first rectangular regions of 132 mm × 104 mm are overlapped with second rectangular regions of 104 mm × 132 mm, the first rectangular regions being parallel to four sides of the main surfaces of the substrates centered at intersections of diagonal lines of the main surfaces of the substrates and the second rectangular regions being orthogonal to the first rectangular regions and parallel to the four sides of the main surfaces of the substrates centered at the intersections of the diagonal lines of the main surfaces of the substrates.

Here, it was evaluated whether or not the shapes give the predetermined TTV on a fact that:
whether or not the difference (TTV1') between the highest height and the lowest height of the TTV1' map excluding the primary component is 35 nm or less, and the difference (TTV2') between the highest height and the lowest height of the TTV2' map excluding the primary component and the secondary component is 25 nm or less in the predicted pseudo TTV map within the cross-shaped region formed in the case where:

(1) the first main surface and the second main surface of the substrate are arranged along the substantially vertical direction, and the calculation region in the regular square tubular shape is set that extends in the horizontal direction through the four sides of the square of 132 mm × 132 mm along the four sides of the first main surface and the second main surface in the central portions of the first main surface and the second main surface;
(2) the portion of the first main surface within the calculation region is cut out in the state of facing the first main surface as the first region face;
(3) the vertical face is set that passes through the reference point which is the one arbitrary point on the central axis of the regular square cylinder in the calculation region and is orthogonal to the central axis as the reference plane, the rotation axis is set that passes through the reference point and is parallel to any one side of the four sides of the regular square, which is the intersection line between the regular square cylinder in the calculation region and the vertical face, and the portion of the second main surface within the calculation region is cut out in the state of facing the second main surface by rotating the substrate by 180 degrees along the rotation axis from the state of facing the first main surface as the second region face;

(4) the least-square plane is calculated in the each of the first region face and the second region face;

(5) the first region face and the second region face is converted into the height map of the first region face and the height map of the second region face based on the position of the each of the first region face and the second region face on the respective least-square plane;

(6) the height map of the second region face is set as the inverted height map of the second region face by symmetrically moving the height map with respect to the perpendicular face passing through the rotation axis in (3) and along the 90 degree direction of the rotation in (3);

(7) the predicted pseudo TTV map is created by adding up the height of the height map of the first region face and the height of the inverted height map of the second region face at the position (the X coordinate, the Y coordinate) on the respective reference plane; and

(8) the first rectangular region of 132 mm × 104 mm is overlapped with the second rectangular region of 104 mm × 132 mm in the predicted pseudo TTV map, the first rectangular region being parallel to the four sides of the main surfaces of the substrate centered at the intersections of the diagonal lines of the main surfaces of the substrate, and the second rectangular region being orthogonal to the first rectangular region and parallel to the four sides of the main surfaces of the substrate centered at the intersections of the diagonal lines of the main surfaces of the substrate.

For the surface shapes after the local processing step at a first time, the predicted shapes (the predicted pseudo TTV map) of the main surfaces of each of the glass substrates after the finish polishing are created, and the results of evaluating the TTV 1' in the predicted pseudo TTV1' map and the TTV2' in the predicted pseudo TTV2' map are shown in Table 1.

In any of the substrates, the TTV1' and the TTV2' were not equal to or less than predetermined values in the processing at the first time. Accordingly, the local processing was performed by repeating steps (A) to (D) until the TTV1' and the TTV2' were equal to or less than the predetermined values. Values of the TTV1' and the TTV2' being equal to or less than the predetermined values and number of times of steps (A) to (D) performed until the TTV1' and the TTV2' were equal to or less than the predetermined values are shown in Table 1. As a result, in any of the glass substrates, the TTV1' was 35 nm or less and the TTV2' was 25 nm or less, and thus it was evaluated that a shape of the main surface having the predetermined flatness was obtained, and the finish polishing step was performed.

The glass substrates were set on a carrier of a polishing apparatus to which the soft polishing cloth of the suede type was applied, polished by using the polishing solution of the colloidal silica, washed with the washing solution containing the KOH after being polished to remove the colloidal silica, and dried to obtain the mask blank substrate. The shapes of the first main surface and the second main surface of the mask blank substrate obtained were measured with the surface shape measurement apparatus (UltraFlat, manufactured by Tropel Corporation) to create the pseudo TTV map and the TTV1, the TTV2, and the flatness of the first main surface were evaluated. Results are shown in Table 1.

Table 1

| Substrate | After local processing | | | | | After finish polishing | | |
|---|---|---|---|---|---|---|---|---|
| | First time | | Number of times X | Xth time | | TTV1 [nm] | TTV2 [nm] | Flatness [nm] |
| | TTV1' [nm] | TTV2' [nm] | | TTV1' [nm] | TTV2' [nm] | | | |
| 1-1 | 37 | 27 | 2 | 16 | 16 | 31 | 17 | 19 |
| 1-2 | 78 | 70 | 2 | 30 | 22 | 33 | 23 | 32 |
| 1-3 | 91 | 88 | 4 | 26 | 21 | 27 | 25 | 22 |
| 1-4 | 81 | 68 | 3 | 24 | 21 | 22 | 24 | 19 |
| 1-5 | 29 | 26 | 2 | 17 | 16 | 19 | 20 | 18 |
| 1-6 | 50 | 31 | 2 | 26 | 20 | 33 | 25 | 20 |

Comparative Example 1

Fifteen glass substrates (sizes of the first main surfaces and the second main surfaces of 152 mm × 152 mm square, and the thickness of 6.35 mm) made from $SiO_2$ and $TiO_2$ ($TiO_2$ concentration of about 7 wt%) were prepared. The end faces (four faces other than the main surfaces) of the each of the glass substrates were subjected to the chamfering processing and the grinding processing, and further, the two main surfaces were subjected to the rough polishing and the precision polishing with the polishing solution containing the cerium oxide abrasive grains. Thereafter, the fifteen glass substrates (a substrate C1-1 to a substrate C1-15) were set on the carrier of the double-side polishing apparatus to which the soft polishing cloth of the suede type was applied, and the first main surfaces and the second main surfaces were subjected to the ultra-precision polishing by using the polishing solution of colloidal silica abrasive grains. After the ultra-precision polishing, the silica nanoparticles were removed by washing the main surfaces with the washing solution containing the KOH, and after drying, the shapes of the first main surfaces and the second main surfaces were measured with the surface shape measurement apparatus (UltraFlat, manufactured by Tropel Corporation).

Next, the local processing step was performed. First, the processing conditions for the local processing were determined on the basis of the shapes of the main surfaces obtained, and the first main surfaces and the second main surfaces of the glass substrates were locally processed by the local processing apparatus based on the processing conditions determined. As the local processing apparatus, the local processing apparatus described in JP-A 2010-194705 (Patent Document 2) was used. The local processing using this apparatus polishes all the surfaces of the substrates while controlling a moving speed of a fine polishing tool, and target shapes can be obtained by slowly moving the polishing tool on a relatively convex portion and rapidly moving the polishing tool on a relatively concave portion. As the processing tool of the local processing apparatus, the wool felt buff was used, and as the polishing slurry, the silica nanoparticles (AJ-3540, manufactured by Nissan Chemical Corporation) mixed with the small amount of the defoaming agent (Shin-Etsu Silicone KS-537, manufactured by Shin-Etsu Chemical Co., Ltd.) were used.

The glass substrates after the local processing were washed with the washing solution containing the KOH to remove the silica nanoparticles, dried, and then the shapes of the first main surfaces and the second main surfaces were measured with the surface shape measurement apparatus (UltraFlat, manufactured by Tropel Corporation).

Here, in order to grasp the changes in the shapes of the main surfaces after the finish polishing with respect to the surfaces after the local processing, another glass substrate was used, similarly, subjected up to the local processing, further, subjected to the finish polishing similar to the finish polishing to be described later to grasp the changes in the shapes of the surfaces before and after the finish polishing step in advance. Thereafter, for the fifteen glass substrates (the substrates C1-1 to the substrate C1-15) after the local processing, the shapes of the surfaces after the finish polishing were predicted by applying the changes grasped in the shapes of the main surfaces to the shapes of the main surfaces of the glass substrates after the local processing.

Next, it was evaluated whether or not the predicted shapes after the finish polishing step were shapes that give the predetermined TTV. The shapes of the surfaces of the glass substrates after the local processing and the shapes of the surfaces predicted after the finish polishing were evaluated in the cross-shaped regions formed in the case where the first rectangular regions of 132 mm × 104 mm are overlapped with the second rectangular regions of 104 mm × 132 mm, the first rectangular regions being parallel to the four sides of the main surfaces of the substrates centered at the intersections of the diagonal lines of the main surfaces of the substrates and the second rectangular regions being orthogonal to the first rectangular regions and parallel to the four sides of the main surfaces of the substrates centered at the intersections of the diagonal lines of the main surfaces of the substrates. Whether or not the shapes give the predetermined TTV was evaluated in a similar manner as in Example 1.

For the surface shapes after the local processing step at the first time, the predicted shapes (the predicted pseudo TTV map) of the main surfaces of each of the glass substrates after the finish polishing are created, and the results of evaluating the TTV1' in the predicted pseudo TTV1' map and the TTV2' in the predicted pseudo TTV2' map are shown in Table 2.

In any of the substrates, the TTV1' and the TTV2' were not equal to or less than the predetermined values in the processing at the first time, but the finish polishing step was performed without changes.

The glass substrates were set on the carrier of the polishing apparatus to which the soft polishing cloth of the suede type was applied, polished by using the polishing solution of the colloidal silica, washed with the washing solution containing the KOH after being polished to remove the colloidal silica, and dried to obtain the mask blank substrate. The shapes of the first main surface and the second main surface of the mask blank substrate obtained were measured with the surface shape measurement apparatus (UltraFlat, manufactured by Tropel Corporation) to create the pseudo TTV map, and the TTV1 and the TTV2 were evaluated. Results are shown in Table 2.

Table 2

| Substrate | After local processing | | After finish polishing | |
|---|---|---|---|---|
| | TTV1' [nm] | TTV2' [nm] | TTV1 [nm] | TTV2 [nm] |
| C1-1 | 82 | 37 | 85 | 34 |
| C 1-2 | 79 | 41 | 80 | 43 |
| C 1-3 | 76 | 39 | 74 | 47 |
| C1-4 | 72 | 41 | 71 | 32 |
| C 1-5 | 71 | 55 | 70 | 58 |
| C 1-6 | 64 | 38 | 67 | 47 |
| C1-7 | 60 | 77 | 61 | 74 |
| C1-8 | 54 | 49 | 59 | 41 |
| C1-9 | 57 | 52 | 59 | 53 |
| C1-10 | 61 | 41 | 53 | 41 |
| C1-11 | 52 | 51 | 53 | 51 |
| C1-12 | 55 | 33 | 52 | 38 |
| C1-13 | 58 | 42 | 52 | 41 |
| C1-14 | 52 | 38 | 50 | 47 |
| C1-15 | 50 | 52 | 49 | 40 |

The mask blank substrate obtained in the Examples has the TTV1 of 35 nm or less and the TTV2 of 25 nm or less, and from such mask blank substrate, the exposure mask having an extremely good flatness when attracted to the exposure machine can be obtained, and it can be expected that a good exposure result can be obtained as the exposure mask for a next-generation high-NA exposure machine.

**Claims**

1. A mask blank substrate having two main surfaces of a first main surface and a second main surface of 152 mm × 152 mm square and a thickness of 6.35 mm, wherein

   in a pseudo TTV map obtained by adding up a height map of the first main surface and a height map of the second main surface based on a position of each of the first main surface and the second main surface on a respective least-square plane,
   a difference (TTV1) between a highest height and a lowest height of a TTV1 map, is 35 nm or less, excluding a primary component when a plane function approximated by a first-order polynomial is derived in fitting of the pseudo TTV map, and a difference (TTV2) between a highest height and a lowest height of a TTV2 map, is 25 nm or less, excluding a primary component and a secondary component when a curved-surface function approximated by up to a second-order polynomial is derived in the fitting of the pseudo TTV map,
   within a cross-shaped region formed in a case where a first rectangular region of 132 mm × 104 mm is overlapped with a second rectangular region of 104 mm × 132 mm, the first rectangular region being parallel to four sides of the main surfaces of the substrate centered at intersections of diagonal lines of the main surfaces of the substrate, and the second rectangular region being orthogonal to the first rectangular region and parallel to the four sides of the main surfaces of the substrate centered at the intersections of the diagonal lines of the main surfaces of the substrate.

2. The mask blank substrate according to claim 1, wherein a flatness of the first main surface within the cross-shaped region is 35 nm or less.

3. A manufacturing method of a mask blank substrate having two main surfaces of a first main surface and a second main surface of 152 mm × 152 mm square and a thickness of 6.35 mm, the manufacturing method comprising:

a local processing step for at least one of the first main surface and the second main surface, and a finish polishing step subsequent to the local processing step, wherein
the local processing step includes:

(A) a step of locally processing the at least one of the first main surface and the second main surface;
(B) a step of measuring a shape of the main surface locally processed after step (A) as the shape of the main surface before the finish polishing step;
(C) a step of predicting the shape after the finish polishing step of the main surface locally processed, by applying a change in a surface shape in a finish polishing step grasped in advance to the shape of the main surface obtained in step (B) before the finish polishing step; and
(D) a step of evaluating whether or not the shape after the finish polishing step predicted in step (C) is a shape giving a predetermined TTV.

**4.** The manufacturing method according to claim 3, wherein the shape giving the predetermined TTV in step (D) is a shape where in a predicted pseudo TTV map within a cross-shaped region formed in a case where:

(1) the first main surface and the second main surface of the substrate are arranged along a substantially vertical direction, and a calculation region in a regular square tubular shape is set that extends in a horizontal direction through four sides of a square of 132 mm × 132 mm along four sides of the first main surface and the second main surface in central portions of the first main surface and the second main surface;
(2) a portion of the first main surface within the calculation region is cut out in a state of facing the first main surface as a first region face;
(3) a vertical face is set that passes through a reference point which is one arbitrary point on a central axis of a regular square cylinder in the calculation region and is orthogonal to the central axis as a reference plane, a rotation axis is set that passes through the reference point and is parallel to any one side of four sides of a regular square, which is one intersection line between the regular square cylinder in the calculation region and the vertical face, and a portion of the second main surface within the calculation region is cut out in a state of facing the second main surface by rotating the substrate by 180 degrees along the rotation axis from the state of facing the first main surface as a second region face;
(4) a least-square plane is calculated in each of the first region face and the second region face;
(5) the first region face and the second region face are converted into a height map of the first region face and a height map of the second region face based on a position of each of the first region face and the second region face on a respective least-square plane;
(6) the height map of the second region face is set as an inverted height map of the second region face by symmetrically moving the height map with respect to a perpendicular face passing through the rotation axis and along a 90 degree direction of the rotation;
(7) a predicted pseudo TTV map is created by adding up a height of the height map of the first region face and a height of the inverted height map of the second region face at the position (a X coordinate, Y coordinate) on the respective reference plane; and
(8) a first rectangular region of 132 mm × 104 mm is overlapped with a second rectangular region of 104 mm × 132 mm in the predicted pseudo TTV map, the first rectangular region being parallel to the four sides of the main surfaces of the substrate centered at intersections of diagonal lines of the main surfaces of the substrate, and the second rectangular region being orthogonal to the first rectangular region and parallel to the four sides of the main surfaces of the substrate centered at the intersections of the diagonal lines of the main surfaces of the substrate,

a difference (TTV1') between a highest height and a lowest height of a TTV1' map, is 35 nm or less, excluding a primary component when a plane function approximated by a first-order polynomial is derived in fitting of the predicted pseudo TTV map, and a difference (TTV2') between a highest height and a lowest height of a TTV2' map, is 25 nm or less, excluding a primary component and a secondary component when a curved-surface function approximated by a second-order polynomial is derived in the fitting of the predicted pseudo TTV map.

# FIG.1A

# FIG.1B

FIGURE 2

# FIG.2A

# FIG.2B

FIGURE 3

# FIG.3A  FIG.3B  FIG.3C

FIGURE 4

# FIG.4

FIGURE 5

# FIG.5A

# FIG.5B

# FIG.5C

**REFERENCES CITED IN THE DESCRIPTION**

**Patent documents cited in the description**

- WO 2016098452 A

- JP 2010194705 A